(19) Europäisches Patentamt
European Patent Office
Office européen des brevets

(11) **EP 3 252 438 B1**

(12) **EUROPÄISCHE PATENTSCHRIFT**

(45) Veröffentlichungstag und Bekanntmachung des Hinweises auf die Patenterteilung:
**24.06.2020 Patentblatt 2020/26**

(51) Int Cl.:
**G01F 1/716** (2006.01)

(21) Anmeldenummer: **17169654.5**

(22) Anmeldetag: **05.05.2017**

(54) **VERFAHREN ZUM BETREIBEN EINES KERNMAGNETISCHEN DURCHFLUSSMESSGERÄTS UND KERNMAGNETISCHES DURCHFLUSSMESSGERÄT**

METHOD FOR OPERATING A NUCLEAR MAGNETIC RESONANCE FLOW METER AND NUCLEAR MAGNETIC RESONANCE FLOW METER

PROCÉDÉ DE FONCTIONNEMENT D'UN DÉBITMÈTRE MAGNÉTIQUE NUCLÉAIRE ET DÉBITMÈTRE MAGNÉTIQUE NUCLÉAIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.05.2016 DE 102016108996**

(43) Veröffentlichungstag der Anmeldung:
**06.12.2017 Patentblatt 2017/49**

(73) Patentinhaber: **Krohne AG**
**4019 Basel (CH)**

(72) Erfinder: **CERIONI, Lucas Matias Ceferino**
**3311 GN Dordrecht (NL)**

(74) Vertreter: **Gesthuysen Patent- und Rechtsanwälte**
**Patentanwälte**
**Huyssenallee 100**
**45128 Essen (DE)**

(56) Entgegenhaltungen:
**WO-A1-2015/088888** **US-A- 4 570 119**
**US-A- 5 023 551** **US-B2- 6 841 996**

- **Jankees Hogendoorn ET AL: "Magnetic Resonance Technology A New Concept for Multiphase Flow Measurement", , 25. Oktober 2013 (2013-10-25), XP055408086, Gefunden im Internet: URL:http://krohne.com/fileadmin/content/files-2/PDF-Upload/2013-NSFMW-Magnetic_Reson ance_Technology-A_New_Concept_for_Multipha se_Flow_Measurement.pdf [gefunden am 2017-09-19]**

## Beschreibung

Die Erfindung betrifft zum einen ein Verfahren zum Betreiben eines kernmagnetischen Durchflussmessgeräts. Das kernmagnetische Durchflussmessgerät weist dabei zur Durchführung des Verfahrens ein Messrohr auf, wobei im Messrohr ein Medium vorhanden ist und das Medium im Messrohr magnetisiert wird.

Die Erfindung betrifft zum anderen auch ein kernmagnetisches Durchflussmessgerät. Das kernmagnetische Durchflussmessgerät weist ein Messrohr, eine Magnetisierungseinrichtung und eine Messeinrichtung auf. Im Betrieb des kernmagnetischen Durchflussmessgeräts ist ein Medium im Messrohr vorhanden und die Magnetisierungseinrichtung magnetisiert das Medium im Messrohr.

Ein kernmagnetisches Durchflussmessgerät verwendet zur Analyse und insbesondere zur Durchflussmessung eines im Messrohr vorhandenen Mediums, das entweder im Messrohr stillsteht oder durch das Messrohr strömt, kernmagnetische Messabläufe. Kernmagnetische Messabläufe beeinflussen die Präzession von Atomkernen eines Mediums bei Anwesenheit eines makroskopischen Magnetfelds, welches das Medium zuvor magnetisiert hat, durch Anregung der Atomkerne zu kernmagnetischen Resonanzen und werten die kernmagnetischen Resonanzen aus. Ein kernmagnetisches Durchflussmessgerät weist deshalb zur Erzeugung eines Magnetfelds in einem im Messrohr vorhandenen Medium eine Magnetisierungseinrichtung und zur Anregung des Mediums im Messrohr und zur Messung der Wirkung der Anregung auf das Medium im Messrohr eine Messeinrichtung auf. Dabei ist die Messeinrichtung auch ausgebildet, Verfahren zum Betreiben eines kernmagnetischen Durchflussmessgeräts auszuführen.

Die Atomkerne der Elemente, die einen Kernspin besitzen, besitzen auch ein durch den Kernspin hervorgerufenes magnetisches Moment. Der Kernspin kann als ein durch einen Vektor beschreibbarer Drehimpuls aufgefasst werden und entsprechend kann auch das magnetische Moment durch einen Vektor beschrieben werden, der parallel zum Vektor des Drehimpulses ist. Die Anwesenheit eines makroskopischen Magnetfelds bewirkt einen Überschuss an Atomkernen mit magnetischen Momenten in einem Medium, die parallel zum makroskopischen Magnetfeld ausgerichtet sind, wodurch das Medium eine makroskopische Magnetisierung aufweist, die durch einen Vektor beschrieben werden kann. Eine makroskopische Magnetisierung eines Mediums parallel zum makroskopischen Magnetfeld wird auch als longitudinale Magnetisierung bezeichnet. Der zeitliche Verlauf der makroskopischen Magnetisierung in einem makroskopischen Magnetfeld wird als longitudinale Relaxation bezeichnet und durch eine longitudinale Relaxationszeitkonstante $T_1$ charakterisiert. Die longitudinale Relaxation wird auch als Spin-Gitter-Relaxation und die longitudinale Relaxationszeitkonstante als Spin-Gitter-Relaxationszeitkonstante bezeichnet.

Der Vektor des magnetischen Moments eines Atomkerns präzessiert bei Anwesenheit eines makroskopischen Magnetfelds wie dem durch die Magnetisierungseinrichtung erzeugten Magnetfeld um den Vektor des makroskopischen Magnetfelds an der Stelle des Atomkerns. Die Frequenz der Präzession wird als Larmorfrequenz $\omega_L$ bezeichnet und ist proportional zum Betrag der Magnetstärke $B$ des Magnetfelds. Die Larmorfrequenz berechnet sich gemäß $\omega_L = \gamma\,B$. Darin ist $\gamma$ das gyromagnetische Verhältnis, welches für Wasserstoffkerne maximal ist.

Eine Beeinflussung von Atomkernen mit einem magnetischen Moment in einem magnetisierten Medium erfolgt grundsätzlich durch Einstrahlen von elektromagnetischen Pulsen in das Medium, wobei die elektromagnetischen Pulse die Larmorfrequenz aufweisen. Eine Anregung von Atomkernen mit einem magnetischen Moment in einem magnetisierten Medium zu kernmagnetischen Resonanzen erfolgt durch geeignete elektromagnetische Pulse, die als Aktivierungspulse bezeichnet werden. Die Anregung bewirkt eine kernmagnetische Resonanz in Form einer transversalen makroskopischen Magnetisierung des Mediums, welche mit der Larmorfrequenz rotiert. Die rotierende transversale makroskopische Magnetisierung kann als ein freier Induktionszerfall, der im Englischen als Free Induction Decay bezeichnet und als FID abgekürzt wird, oder, nach einer Refokussierung, als ein Echosignal gemessen werden. Eine Refokussierung der rotierenden transversalen Magnetisierung ist dann notwendig, wenn die nach der Anregung vorhandene Beziehung der Phasen der einzelnen magnetischen Momente der Atomkerne zueinander zum Beispiel durch Inhomogenitäten im makroskopischen Magnetfeld gestört wird. Eine Refokussierung erfolgt durch geeignete elektromagnetische Pulse, die als Refokussierungspulse bezeichnet werden. Ein geeigneter elektromagnetischer Puls, welcher die transversale rotierende Magnetisierung des Mediums wieder zurück parallel zum makroskopischen Magnetfeld bewegt, wird als Deaktivierungspuls bezeichnet. Darüber hinaus werden noch Inversionspulse verwendet. Das sind geeignete elektromagnetische Pulse, welche die zum makroskopischen Magnetfeld parallele Magnetisierung des Medium invertieren, so dass die Magnetisierung des Mediums antiparallel zum makroskopischen Magnetfeld ist.

Im Folgenden wird ohne Beschränkung der Allgemeingültigkeit ein rechtshändiges kartesisches Koordinatensystem mit einer x-Achse, einer y-Achse und einer z-Achse und einem mathematisch positiven Drehsinn angenommen, wobei die positive z-Richtung parallel zu einem Vektor des makroskopischen Magnetfelds ausgerichtet ist. Somit ist die makroskopische Magnetisierung eines Mediums durch das makroskopische Magnetfeld ebenfalls parallel zur z-Achse ausgerichtet. Ein Aktivierungspuls bewirkt dann Rotation des Vektors der makroskopischen Magnetisierung des Mediums um eine Achse des Koordinatensystems, so das eine rotierende transversale Magnetisierung vorhanden ist, die in der xy-Ebene rotiert. Analog dazu bewirkt ein Deaktivierungspuls eine Rotation des Vektors der makroskopischen Magnetisierung des Medium um eine Achse des Koordinatensystems, so dass wieder nur eine longitudinale Magnetisierung vorhanden ist. Entsprechend bewirkt ein Inversionspuls eine Rotation des Vektors der makroskopischen Magnetisierung des Medium um eine Achse des Koordinatensystems, so dass die longitudinale Magnetisierung nicht mehr parallel zur z-Achse, sondern antiparallel ausgerichtet ist.

Ein im Messrohr vorhandenes Medium kann auch mehrere Phasen aufweisen. Zur Analyse der einzelnen Phasen müssen Atomkerne der einzelnen Phasen zu unterscheidbaren kernmagnetischen Resonanzen anregbar sein. Zum Beispiel sind kernmagnetische Resonanzen voneinander unterscheidbar, wenn die longitudinalen Relaxationen der einzelnen Phasen voneinander verschiedene longitudinale Relaxationszeitkonstanten $T_1$ aufweisen. Da das aus Ölquellen geförderte mehrphasige Medium im Wesentlichen die flüssigen Phasen Rohöl und (Salz-) Wasser und als gasförmige Phase Erdgas aufweist, die Atomkerne aller Phasen Wasserstoffkerne besitzen und sich für gewöhnlich insbesondere die Phasen Rohöl und (Salz-) Wasser durch unterschiedliche longitudinale Relaxationszeitkonstanten $T_1$ auszeichnen, sind kernmagnetische Durchflussmessgeräte für die Analyse und insbesondere für die Durchflussmessung von aus Ölquellen geförderten Medien besonders geeignet.

Somit ist die Kenntnis einer longitudinalen Relaxationszeitkonstanten $T_1$ eines Mediums für gewöhnlich eine Voraussetzung für eine weitere Analyse und insbesondere Durchflussmessung eines Mediums durch das Messrohr eines kernmagnetischen Durchflussmessgeräts. Da eine weitere Analyse und eine Durchflussmessung des Medium während der Bestimmung der longitudinalen Relaxationszeitkonstanten $T_1$ des Mediums oftmals beeinträchtigt sind, sind aus dem Stand der Technik verschiedene Verfahren zum Betreiben eines kernmagnetischen Durchflussmessgeräts und kernmagnetische Durchflussmessgeräte bekannt, die einen reduzierten Zeitaufwand für die Bestimmung einer longitudinalen Relaxationszeitkonstanten $T_1$ zum Ziel haben.

Der Artikel "Magnetic Resonance Technology - A New Concept for Multiphase Flow Measurement" von Jankees Hogendoorn, Andre Boer, Matthias Appel, Hilko de Jong und Rick de Leeuw beschreibt die Entwicklung eines industriell einsetzbaren kernmagnetischen Durchflussmessgeräts für Medien auch mit mehreren Phasen auf Basis von kernmagnetischen Resonanzen.

Die Offenlegungsschrift WO 2015/088888 A1 beschreibt ein Verfahren zum Unterscheiden von gasförmigen und flüssigen Phasen in einem durch ein Rohr strömenden Medium mit mehreren Phasen.

Die Patentschrift US 4,570,119 beschreibt ein Verfahren zur Visualisierung eines Flusses in einer Ebene, wobei eine kernmagnetische Pulssequenz zum Erzeugen von ungeraden und geraden Spin-Echo-Signalen verwendet wird.

Die Patentschrift US 5,023,551 beschreibt verschiedene Pulssequenzen zur Anregung von kernmagnetischen Resonanzen. Neben der Messung von angeregten kernmagnetischen Resonanzen werden auch Magnetfeldstärken und Relaxationszeitkonstanten bestimmt.

Die Patentschrift US 6,841,996 B2 beschreibt ein Verfahren und ein Vorrichtung zur Durchführung von kernmagnetischen Resonanzmessungen an einem strömenden Fluid mit variierten Wartezeiten.

Eine Aufgabe der vorliegenden Erfindung ist daher die Angabe von einem Verfahren zum Betreiben eines kernmagnetischen Durchflussmessgeräts sowie von einem kernmagnetischen Durchflussmessgerät, bei denen der Zeitbedarf für die Bestimmung einer longitudinalen Relaxationszeitkonstanten $T_1$ eines Mediums im Vergleich zum Stand der Technik weiter reduziert ist.

Die Erfindung bezieht sich gemäß einer ersten Lehre auf ein Verfahren zum Betreiben eines kernmagnetischen Durchflussmessgeräts, bei dem die hergeleitete und aufgezeigte Aufgabe gelöst ist. Das erfindungsgemäße Verfahren ist zunächst im Wesentlichen durch die folgenden Verfahrensschritte gekennzeichnet.

In einem Verfahrensschritt wird mindestens ein kernmagnetischer Messablauf am im Messrohr magnetisierten Medium ausgeführt. Der mindestens eine kernmagnetische Messablauf weist einen Inversionspuls und $N = \{2, 3, 4, ...\}$ Akquisitionsvorgänge auf. Jeder der $N$ Akquisitionsvorgänge beginnt zu einem Startzeitpunkt $t_{s,n}$ mit $n = \{1, ..., N\}$ in Bezug auf den mindestens einen kernmagnetischen Messablauf und weist einen Aktivierungspuls, ein erstes Warteintervall mit einer Dauer $\Delta t_d$, einen ersten Refokussierungspuls, ein Echointervall mit einer Dauer $\Delta t_e$, einen zweiten Refokussierungspuls, ein zweites Warteintervall mit der Dauer $\Delta t_d$ und einen Deaktivierungspuls auf. Dabei folgen nach dem Startzeitpunkt $\Delta t_{s,n}$ zeitlich aufeinander der Aktivierungspuls zur Anregung einer kernmagnetischen Resonanz, das erste Warteintervall, der erste Refokussierungspuls, das Echointervall, der zweite Refokussierungspuls, das zweite Warteintervall und der Deaktivierungspuls. Darüber hinaus wird im Echointervall ein Echosignal $s_{e,n}$ eines Echos der kernmagnetischen Resonanz gemessen, wobei vorzugsweise eine Intensität des Echos als Echosignal gemessen wird.

In einem weiteren Verfahrensschritt wird eine longitudinale Relaxationszeitkonstante $T_1$ des Mediums unter Verwendung der Echosignale $s_{e,1}, ..., s_{e,N}$ bestimmt.

Der Inversionspuls, der Aktivierungspuls, der erste und der zweite Refokussierungspuls und der Deaktivierungspuls weisen jeweils entweder einen einzigen geeigneten elektromagnetischen Puls und mehrere geeignete elektromagnetische Pulse auf. Zu den geeigneten elektromagnetischen Pulsen zählen zum Beispiel adiabatische und zusammengesetzte Pulse und Soft- und Hard-Pulse sowie eine beliebige Kombination der aufgeführten Pulse. Der erste und der zweite Refokussierungspuls sind abgesehen von ihrem zeitlichen Auftreten identisch. Auch das erste und das zweite Warteintervall sind abgesehen von ihrem zeitlichen Auftreten identisch. Die Warteintervalle dienen insbesondere dem Abklingen von Störungen.

Ein Vorteil des erfindungsgemäßen Verfahrens gegenüber den aus dem Stand der Technik bekannten Verfahren ist, dass die zum Ausführen des Verfahrens benötigte Zeit reduziert ist.

Um die Ausführungsdauer des Verfahrens weiter zu reduzieren, ist in einer ersten Ausgestaltung des erfindungsgemäßen Verfahrens vorgesehen, dass die Dauer $\Delta t_d$ gemäß

$$\Delta t_d = t_{ref} - \frac{2\Delta t_{90}}{\pi}$$

und/oder die Dauer $\Delta t_e$ gemäß

$$\Delta t_e = 2t_{ref}$$

bestimmt werden bzw. wird. Dabei ist $\Delta t_{ref}$ eine Referenzdauer und $\Delta t_{90}$ eine Dauer des Aktivierungspulses.

In einer Weiterbildung der vorangehenden Ausgestaltung ist vorgesehen, dass die Referenzdauer $\Delta t_{ref}$ unter Verwendung einer Dauer eines Abklingens von Störungen bestimmt wird. Dabei werden die Störungen durch den Aktivierungspuls und/oder den ersten Refokussierungspuls hervorgerufen. In einer Ausführung ist zum Beispiel vorgesehen, dass die Referenzdauer $\Delta t_{ref}$ so lang bemessen wird, dass Störungen auf ein für die Messung des Echosignals tolerierbares Maß abgefallen sind.

Die longitudinale Relaxation folgt zeitlich einem exponentiellen Verlauf, weshalb die Dynamik der longitudinalen Relaxation mit zunehmender Zeit abnimmt. Zur besseren Erfassung der Dynamik ist deshalb in einer weiteren Ausgestaltung vorgesehen, dass ein zeitlicher Abstand von jeweils zwei aufeinanderfolgenden Startzeitpunkten $t_{s,n}$ und $t_{s,n+1}$ derart bestimmt wird, dass der zeitliche Abstand zunimmt. Vorzugsweise nimmt der zeitliche Abstand exponentiell zu.

Wenn mindestens zwei kernmagnetische Messabläufe am im Messrohr magnetisierten Medium ausgeführt werden, ist es vorteilhaft, wenn zwischen den beiden kernmagnetischen Messabläufen Störungen abklingen können.

Deshalb ist in einer weiteren Ausgestaltung des Verfahrens vorgesehen, dass nach den $N$ Akquisitionsvorgängen für ein Wiederholungsintervall mit einer Dauer $\Delta t_w$ gewartet wird. Dabei ist die Dauer $\Delta t_w$ zumindest gleich lang wie der größte Abstand von zwei aufeinanderfolgenden Startzeitpunkten $t_{s,n}$ und $t_{sn+1}$ oder zumindest gleich lang wie der Abstand vom ersten Startzeitpunkt $t_{s,1}$ in Bezug auf ein Ende des Inversionspulses.

Zur Verbesserung der Qualität der Echosignale ist in einer weiteren Ausgestaltung vorgesehen, dass mindestens zwei kernmagnetische Messabläufe derart zeitlich aufeinanderfolgend ausgeführt werden, dass jeweils zwei zeitlich aufeinanderfolgende Echosignale $s_n$ und $s_{n+1}$ in den Echointervallen von verschiedenen kernmagnetischen Messabläufen gemessen werden. Dadurch, dass jeweils zwei zeitlich aufeinanderfolgende Echosignale $s_n$ und $s_{n+1}$ zu unterschiedlichen und zeitlich aufeinanderfolgenden Messabläufen gehören, wird der zeitliche Abstand der Messungen der Echosignale $s_n$ und $s_{n+1}$ vergrößert, wodurch die Qualität der Messungen verbessert wird.

Diese Ausgestaltung wird im Folgenden allgemeingültig anhand eines Beispiels beschrieben. In diesem Beispiel wird die longitudinale Relaxationszeitkonstante $T_1$ des Mediums unter Verwendung der Echosignale $s_{e,1}$, ..., $s_{e,9}$ bestimmt. Somit werden insgesamt $N$ = 9 Akquisitionsvorgänge ausgeführt, wobei sich die N = 9 Akquisitionsvorgänge gleichmäßig auf einen ersten, einen zweiten und einen dritten kernmagnetischen Messablauf verteilen.

Im ersten kernmagnetischen Messablauf wird nach dem Startzeitpunkt $t_{s,1}$ das Echosignal $s_{e,1}$, nach dem Startzeitpunkt $t_{s,4}$ das Echosignal $s_{e,4}$ und nach dem Startzeitpunkt $t_{s,7}$ das Echosignal $s_{e,7}$ gemessen.

Im auf den ersten kernmagnetischen Messablauf zeitlich folgenden zweiten kernmagnetischen Messablauf wird nach dem Startzeitpunkt $t_{s,2}$ das Echosignal $s_{e,2}$, nach dem Startzeitpunkt $t_{s,5}$ das Echosignal $s_{e,5}$ und nach dem Startzeitpunkt $t_{s,8}$ das Echosignal $s_{e,8}$ gemessen.

Im auf den zweiten kernmagnetischen Messablauf zeitlich folgenden dritten kernmagnetischen Messablauf wird nach dem Startzeitpunkt $t_{s,3}$ das Echosignal $s_{e,3}$, nach dem Startzeitpunkt $t_{s,6}$ das Echosignal $s_{e,6}$, nach dem Startzeitpunkt $t_{s,9}$ das Echosignal $s_{e,9}$ gemessen.

Dabei sind die Startzeitpunkte $t_{s,n}$ streng monoton steigend, so dass $t_{s,9} > t_{s,8} > t_{s,7} > t_{s,6} > t_{s,5} > t_{s,4} > t_{s,3} > t_{s,2} > t_{s,1}$ ist. Somit ist bei dieser Ausgestaltung der zeitliche Abstand von jeweils zwei aufeinanderfolgenden Echosignalen $s_n$ und $s_{n+1}$ größer als als wenn diese nur während eines einzigen kernmagnetischen Messablaufs gemessen werden.

In einer weiteren Ausgestaltung ist vorgesehen, dass als der Inversionspuls ein +180°$_x$-Puls, als der Aktivierungspuls ein +90°$_x$-Puls, als der Deaktivierungspuls ein -90°$_x$-Puls und als der erste Refokussierungspuls und der zweite Refokussierungspuls jeweils ein +180°$_y$-Puls verwendet werden.

Ein +180°$_x$-Puls ist ein elektromagnetischer Puls, der zur Rotation des Vektors der makroskopischen Magnetisierung um 180° im positiven Drehsinn um die x-Achse des kartesischen Koordinatensystems ausgebildet ist. Ein +90°$_x$-Puls ist ein elektromagnetischer Puls, der zur Rotation des Vektors der makroskopischen Magnetisierung um 90° im positiven Drehsinn um die x-Achse ausgebildet ist und analog ist ein -90°x-Puls ist ein elektromagnetischer Puls, der zur Rotation des Vektors der makroskopischen Magnetisierung um 90° im negativen Drehsinn um die x-Achse ausgebildet ist. Im Gegensatz zu den vorhergehenden Rotationen ist ein +180°y-Puls zur Rotation des Vektors der makroskopischen Magnetisierung um 180° im positiven Drehsinn um die y-Achse ausgebildet.

In einer weiteren Ausgestaltung ist zur Verbesserung der Qualität der gemessenen Echosignale vorgesehen, dass Phasenunterschiede zwischen dem Inversionspuls, dem Aktivierungspuls, dem ersten Refokussierungspuls, dem zweiten Refokussierungspuls, dem Deaktivierungspuls und dem Echosignal periodisch getauscht werden. Im Englischen wird das als Phase Cycling bezeichnet.

In einer Weiterbildung der vorangehenden Ausgestaltung ist vorgesehen, dass ein erster und ein zweiter kernmagnetischer Messablauf derart in Bezug auf eine Phase des Inversionspulses und des Aktivierungspulses im ersten kernmagnetischen Messablauf ausgeführt werden, dass das Folgende gilt:
Im ersten kernmagnetischen Messablauf betragen ein Phasenunterschied des ersten Refokussierungspulses und des zweiten Refokussierungspulses jeweils 90°, ein Phasenunterschied des Deaktivierungspulses 180° und ein Phasenunterschied des Echosignals 0°. Die Phasenunterschiede des Inversionspulses und des Aktivierungspulses betragen jeweils 0°, da diese gerade als Bezug verwendet werden.

Im zweiten kernmagnetischen Messablauf betragen ein Phasenunterschied des Inversionspulses und des Aktivierungspulses jeweils 180°, ein Phasenunterschied des ersten Refokussierungspulses und des zweiten Refokussierungspulses jeweils 90°, ein Phasenunterschied des Deaktivierungspulses 0° und ein Phasenunterschied des Echosignals 180°.

In einer zu vorangehenden Weiterbildung alternativen Weiterbildung ist vorgesehen, dass ein erster, ein zweiter, ein dritter und ein vierter kernmagnetischer Messablauf derart in Bezug auf eine Phase des Inversionspulses und des Aktivierungspulses im ersten kernmagnetischen Messablauf ausgeführt werden, dass das Folgende gilt:
Im ersten kernmagnetischen Messablauf betragen ein Phasenunterschied des ersten Refokussierungspulses und des zweiten Refokussierungspulses jeweils 90° und ein Phasenunterschied des Deaktivierungspulses 180° und werden ein positiver Realteil des Echosignals mit einem ersten Kanal und ein positiver Imaginärteil des Echosignals mit einem zweiten Kanal gemessen. Die Phasenunterschiede des Inversionspulses und des Aktivierungspulses betragen jeweils 0°, da diese gerade als Bezug verwendet werden. Der erste und der zweiten Kanal sind zum Beispiel Teil einer Messeinrichtung, welche zur Ausführung des Verfahrens ausgebildet ist.

Im zweiten kernmagnetischen Messablauf betragen ein Phasenunterschied des Inversionspulses und des Aktivierungspulses jeweils 180°, ein Phasenunterschied des ersten Refokussierungspulses und des zweiten Refokussierungspulses jeweils 90° und ein Phasenunterschied des Deaktivierungspulses 0° und werden ein negativer Realteil des Echosignals mit dem ersten Kanal und ein negativer Imaginärteil des Echosignals mit dem zweiten Kanal gemessen.

Im dritten kernmagnetischen Messablauf betragen ein Phasenunterschied des Inversionspulses und des Aktivierungspulses jeweils 90°, ein Phasenunterschied des ersten Refokussierungspulses und des zweiten Refokussierungspulses jeweils 180° und ein Phasenunterschied des Deaktivierungspulses 270° und werden ein negativer Realteil des Echosignals mit dem zweiten Kanal und ein positiver Imaginärteil des Echosignals mit dem ersten Kanal gemessen.

Im vierten kernmagnetischen Messablauf betragen ein Phasenunterschied des Inversionspulses und des Aktivierungspulses jeweils 270°, ein Phasenunterschied des ersten Refokussierungspulses und des zweiten Refokussierungspulses jeweils 180° und ein Phasenunterschied des Deaktivierungspulses 90° und werden ein positiver Realteil des Echosignals mit dem zweiten Kanal und ein negativer Imaginärteil des Echosignals mit dem ersten Kanal gemessen.

Die Erfindung bezieht sich gemäß einer zweiten Lehre auf ein kernmagnetisches Durchflussmessgerät, bei dem die hergeleitete und aufgezeigte Aufgabe gelöst ist. Das erfindungsgemäße kernmagnetische Durchflussmessgerät ist zunächst und im Wesentlichen dadurch gekennzeichnet, dass die Messeinrichtung ausgebildet ist, im Betrieb mindestens einen kernmagnetischen Messablauf am im Messrohr magnetisierten Medium auszuführen. Dabei weist der mindestens eine kernmagnetische Messablauf einen Inversionspuls und $N = \{2, 3, 4, ...\}$ Akquisitionsvorgänge auf. Jeder der $N$ Akquisitionsvorgänge beginnt zu einem Startzeitpunkt $t_{s,n}$ mit $n = \{1, ..., N\}$ in Bezug auf den mindestens einen kernmagnetischen Messablauf und weist einen Aktivierungspuls, ein erstes Warteintervall mit einer Dauer $\Delta t_d$, einem ersten Refokussierungspuls, ein Echointervall mit einer Dauer $\Delta t_e$, einen zweiten Refokussierungspuls, ein zweites Warteintervall mit der Dauer $\Delta t_d$ und einen Deaktivierungspuls auf. Darüber hinaus ist die Messeinrichtung ausgebildet, im Betrieb im Echointervall ein Echosignal $s_{e,n}$ zu messen und eine longitudinale Relaxationszeitkonstantes $T_1$ des Mediums unter Verwendung der Echosignale $s_{e,1}, ... s_{e,N}$ zu bestimmen.

In einer bevorzugten Ausgestaltung des erfindungsgemäßen kernmagnetischen Durchflussmessgeräts ist vorgesehen, dass die Messeinrichtung darüber hinaus zum Ausführen eines der beschriebenen Verfahren ausgebildet ist.

Die Ausführungen zum Verfahren zum Betreiben eines kernmagnetischen Durchflussmessgeräts gelten entsprechend für das kernmagnetische Durchflussmessgerät und umgekehrt. Auch wenn das Verfahren in Verbindung mit einem kernmagnetischen Durchflussmessgerät beschrieben worden ist, so ist das Verfahren nicht auf solche beschränkt, sondern ebenfalls zum Betreiben von anderen kernmagnetischen Geräten geeignet. Ebenso sind die Ausführungen zu dem kernmagnetischen Durchflussmessgerät nicht auf solche beschränkt, sondern auch auf andere kernmagnetische Geräte übertragbar.

Im Einzelnen ist eine Vielzahl von Möglichkeiten gegeben, das erfindungsgemäße Verfahren und das erfindungsgemäße kernmagnetische Durchflussmessgerät auszugestalten und weiterzubilden. Dazu wird verwiesen sowohl auf die den unabhängigen Patentansprüchen nachgeordneten Patentansprüche als auch auf die nachfolgende Beschreibung eines bevorzugten Ausführungsbeispiels in Verbindung mit der Zeichnung. In der Zeichnung zeigt

Fig. 1 ein Ausführungsbeispiel eines kernmagnetischen Durchflussmessgeräts und

Fig. 2 einen schematischen und nicht maßstabsgetreuen zeitlichen Ablauf eines Verfahrens zum Betreiben des kernmagnetischen Durchflussmessgeräts.

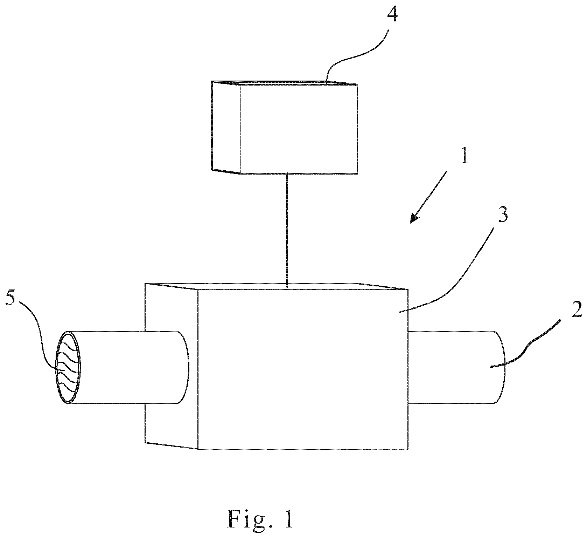

Fig. 1 zeigt in einer abstrahierten perspektivischen Darstellung das kernmagnetische Durchflussmessgerät 1. Das kernmagnetische Durchflussmessgerät 1 weist das Messrohr 2, die Magnetisierungseinrichtung 3 und die Messeinrichtung 4 auf. Da das kernmagnetische Durchflussmessgerät 1 in Betrieb ist, ist das Medium 5 im Messrohr 2 vorhanden und magnetisiert die Magnetisierungseinrichtung 3 das im Messrohr 2 vorhandene Medium 5.

Die Messeinrichtung 4 führt das folgende Verfahren zum Betreiben des kernmagnetischen Durchflussmessgeräts 1 aus. Das Verfahren läuft kontinuierlich während des Betriebs ab, weshalb auch kontinuierlich zeitlich aufeinanderfolgend kernmagnetische Messaufläufe am im Messrohr 2 vorhandenen Medium 5 ausgeführt werden. Nach Beendigung des Verfahrens für die Messeinrichtung 4 zum Beispiel ein Verfahren zur Durchflussmessung des Mediums 5 durch das Messrohr 2 aus.

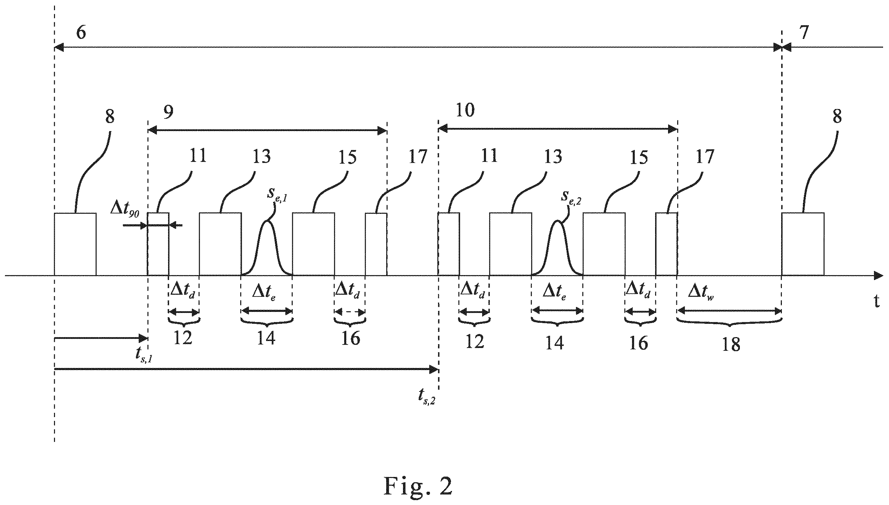

In Fig. 2 sind der erste Messablauf 6 und ein Teil des zweiten Messablaufs 7 schematisch und nicht maßstabsgetreu dargestellt. Jeder der Messabläufe 6, 7 weist jeweils den Inversionspuls 8 und $N=2$ Akquisitionsvorgänge, also den ersten Akquisitionsvorgang 9 und den zweiten Akquisitionsvorgang 10 auf. Für gewöhnlich wird die Anzahl der Akquisitionsvorgänge deutlich größer sein. Für die Erläuterung des Verfahrens ist eine größere Anzahl von Akquisitionsvorgängen jedoch nicht erforderlich. Der erste Akquisitionsvorgang 9 beginnt zum Startzeitpunkt $t_{s,1}$ ($n=1$) und der zweite Akquisitionsvorgang 10 zum Startzeitpunkt $t_{s,2}$ ($n=N=2$). Die Startzeitpunkte $t_{s,1}$ und $t_{s,2}$ sind dabei jeweils auf den Anfang des ersten Messablaufs 6 bezogen. Der Anfang des Messablaufs 6 fällt zeitlich mit dem Anfang des Inversionspulses 8 zusammen. Jeder der Akquisitionsvorgänge 9, 10 weist jeweils den Aktivierungspuls 11 mit der Dauer $\Delta t_{90}$, das erste Warteintervall 12 mit der Dauer $\Delta t_d$, den ersten Refokussierungspuls 13, das Echointervall 14 mit einer Dauer $\Delta t_e$, den zweiten Refokussierungspuls 15, das zweite Warteintervall 16 mit der Dauer $\Delta t_d$ und den Deaktivierungspuls 17 auf.

Im Echointervall 14 des ersten Akquisitionsvorgangs 9 wird das erste Echosignal $s_{e,1}$ und im Echointervall 14 des zweiten Akquisitionsvorgangs 10 wird das zweite Echosignal $s_{e,2}$ gemessen. Unter Verwendung der Echosignale $s_{e,1}$ und $s_{e,1}$ wird eine longitudinale Relaxationszeitkonstante $T_1$ des Mediums 5 bestimmt.

Nach den $N=2$ Akquisitionsvorgängen wird für das Wiederholungsintervall 18 mit der Dauer $\Delta t_w$ gewartet, bevor der zweite Messablauf 7 durch den Inversionspuls 8 beginnt.

## Bezugszeichen

| | |
|---|---|
| 1 | Kernmagnetisches Durchflussmessgerät |
| 2 | Messrohr |
| 3 | Magnetisierungseinrichtung |
| 4 | Messeinrichtung |
| 5 | Medium |
| 6 | Erster kernmagnetischer Messablauf |
| 7 | Zweiter kernmagnetischer Messablauf |
| 8 | Inversionspuls |
| 9 | Erster Akquisitionsvorgang |
| 10 | Zweiter Akquisitionsvorgang |
| 11 | Aktivierungspuls |
| 12 | Erstes Warteintervall |
| 13 | Erster Refokussierungspuls |
| 14 | Echointervall |
| 15 | Zweiter Refokussierungspuls |
| 16 | Zweites Warteintervall |
| 17 | Deaktivierungspuls |
| 18 | Wiederholungsintervall |
| | |
| $N$ | Anzahl der Akquisitionsvorgänge |
| $n$ | Ein Akquisitionsvorgang aus der Menge {1, ..., $N$} der Akquisitions-vorgänge |
| $s_{e,n}$ | $n$-tes Echosignal |
| $T_1$ | Longitudinale Relaxationszeitkonstante des Mediums |
| $t_{s,n}$ | Startzeitpunkt des $n$-ten Akquisitionsvorgangs in Bezug auf einen kernmagnetischen Messablauf |
| $t_{ref}$ | Referenzdauer |
| $\Delta t_d$ | Dauer des Warteintervalls |
| $\Delta t_e$ | Dauer des Echointervalls |
| $\Delta t_w$ | Dauer des Wiederholungsintervalls |
| $\Delta t_{90}$ | Dauer des Aktivierungspulses |

**Patentansprüche**

1. Verfahren zum Betreiben eines kernmagnetischen Durchflussmessgeräts (1), wobei das kernmagnetische Durchflussmessgerät (1) ein Messrohr (2) aufweist, ein Medium (5) im Messrohr (2) vorhanden ist und das Medium (5) im Messrohr (2) magnetisiert wird,
   **dadurch gekennzeichnet,**

   - **dass** mindestens ein kernmagnetischer Messablauf (6, 7) am im Messrohr (2) magnetisierten Medium (5) ausgeführt wird,
   - **dass** der mindestens eine kernmagnetische Messablauf (6, 7) einen Inversionspuls (8) und $N = \{2, 3, 4, ...\}$ Akquisitionsvorgänge (9, 10) aufweist,
   - **dass** jeder der $N$ Akquisitionsvorgänge (9, 10) zu einem Startzeitpunkt $t_{s,n}$ mit $n = \{1, ..., N\}$ in Bezug auf den mindestens einen kernmagnetischen Messablauf (6, 7) beginnt und einen Aktivierungspuls (11), ein erstes Warteintervall (12) mit einer Dauer $\Delta t_d$, einen ersten Refokussierungspuls (13), ein Echointervall (14) mit einer Dauer $\Delta t_e$, einen zweiten Refokussierungspuls (15), ein zweites Warteintervall (16) mit der Dauer $\Delta t_d$ und einen Deaktivierungspuls (17) aufweist,
   - **dass** im Echointervall (14) ein Echosignal $s_{e,n}$ gemessen wird, und
   - **dass** eine longitudinale Relaxationszeitkonstante $T_1$ des Mediums (5) unter Verwendung der Echosignale $s_{e,1}, ..., s_{e,N}$ bestimmt wird.

2. Verfahren nach Anspruch 1, **dadurch gekennzeichnet, dass** die Dauer $\Delta t_d$ gemäß

$$\Delta t_d = t_{ref} - \frac{2\Delta t_{90}}{\pi}$$

und/oder die Dauer $\Delta t_e$ gemäß

$$\Delta t_e = 2t_{ref}$$

bestimmt werden bzw. wird, wobei $\Delta t_{ref}$ eine Referenzdauer und $\Delta t_{90}$ eine Dauer des Aktivierungspulses (11) sind.

3. Verfahren nach Anspruch 2, **dadurch gekennzeichnet, dass** die Referenzdauer $\Delta t_{ref}$ unter Verwendung einer Dauer eines Abklingens von Störungen bestimmt wird, wobei die Störungen durch den Aktivierungspuls (11) und/oder den ersten Refokussierungspuls (13) hervorgerufen werden.

4. Verfahren nach einem der Ansprüche 1 bis 3, **dadurch gekennzeichnet, dass** ein zeitlicher Abstand von jeweils zwei aufeinanderfolgenden Startzeitpunkten $t_{s,n}$ und $t_{sn+1}$ derart bestimmt wird, dass der zeitliche Abstand zunimmt, vorzugsweise exponentiell zunimmt.

5. Verfahren nach einem der Ansprüche 1 bis 4, **dadurch gekennzeichnet, dass** nach den $N$ Akquisitionsvorgängen (9, 10) für ein Wiederholungsintervall (18) mit einer Dauer $\Delta t_w$ gewartet wird und dass die Dauer $\Delta t_w$ zumindest gleich lang ist wie der größte zeitliche Abstand von zwei aufeinanderfolgenden Startzeitpunkten $t_{s,n}$ und $t_{s,n+1}$ oder zumindest gleich lang ist wie der zeitliche Abstand vom ersten Startzeitpunkt $t_{s,1}$ in Bezug auf ein Ende des Inversionspulses (8).

6. Verfahren nach einem der Ansprüche 1 bis 5, **dadurch gekennzeichnet, dass** mindestens zwei kernmagnetische Messabläufe (6, 7) derart ausgeführt werden, dass jeweils zwei zeitlich aufeinanderfolgende Echosignale $s_{e,n}$ und $s_{e,n+1}$ in den Echointervallen (14) von verschiedenen kernmagnetischen Messabläufen (6, 7) gemessen werden.

7. Verfahren nach einem der Ansprüche 1 bis 6, **dadurch gekennzeichnet, dass** als der Inversionspuls (8) ein $+180°_x$-Puls, als der Aktivierungspuls (11) ein $+90°_x$-Puls, als der Deaktivierungspuls (17) ein $-90°_x$-Puls und als der erste Refokussierungspuls (13) und der zweite Refokussierungspuls (15) jeweils ein $+180°_y$-Puls verwendet werden.

8. Verfahren nach einem der Ansprüche 1 bis 7, **dadurch gekennzeichnet, dass** Phasenunterschiede zwischen dem Inversionspuls (8), dem Aktivierungspuls (11), dem ersten Refokussierungspuls (13), dem zweiten Refokussierungspuls (15), dem Deaktivierungspuls (17) und dem Echosignal $s_{e,n}$ periodisch getauscht werden.

9. Verfahren nach Anspruch 8, **dadurch gekennzeichnet,**

   - **dass** ein erster kernmagnetischer Messablauf (6) und ein zweiter kernmagnetischer Messablauf (7) derart in Bezug auf eine Phase des Inversionspulses (8) und des Aktivierungspulses (11) im ersten kernmagnetischen Messablauf (6) ausgeführt werden,
   - **dass** im ersten kernmagnetischen Messablauf (6) ein Phasenunterschied des ersten Refokussierungspulses (13) und des zweiten Refokussierungspulses (15) jeweils 90°, ein Phasenunterschied des Deaktivierungspulses (17) 180° und ein Phasenunterschied des Echosignals $s_{e,1}$ 0° betragen und

- **dass** im zweiten kernmagnetischen Messablauf (7) ein Phasenunterschied des Inversionspulses (8) und des Aktivierungspulses (11) jeweils 180°, ein Phasenunterschied des ersten Refokussierungspulses (13) und des zweiten Refokussierungspulses (15) jeweils 90°, ein Phasenunterschied des Deaktivierungspulses (17) 0° und ein Phasenunterschied des Echosignals $s_{e,2}$ 180° betragen.

10. Verfahren nach Anspruch 8, **dadurch gekennzeichnet,**

- **dass** ein erster kernmagnetischer Messablauf (6), ein zweiter kernmagnetischer Messablauf (7), ein dritter kernmagnetischer Messablauf und ein vierter kernmagnetischer Messablauf derart in Bezug auf eine Phase des Inversionspulses (8) und des Aktivierungspulses (11) im ersten kernmagnetischen Messablauf (6) ausgeführt werden,
- **dass** im ersten kernmagnetischen Messablauf (6) ein Phasenunterschied des ersten Refokussierungspulses (13) und des zweiten Refokussierungspulses (15) jeweils 90° und ein Phasenunterschied des Deaktivierungspulses (17) 180° betragen und dass ein positiver Realteil des Echosignals $s_{e,1}$ mit einem ersten Kanal und ein positiver Imaginärteil des Echosignals $s_{e,1}$ mit einem zweiten Kanal gemessen werden,
- **dass** im zweiten kernmagnetischen Messablauf (7) ein Phasenunterschied des Inversionspulses (8) und des Aktivierungspulses (11) jeweils 180°, ein Phasenunterschied des ersten Refokussierungspulses (13) und des zweiten Refokussierungspulses (15) jeweils 90° und ein Phasenunterschied des Deaktivierungspulses (17) 0° betragen und dass ein negativer Realteil des Echosignals $s_{e,2}$ mit dem ersten Kanal und ein negativer Imaginärteil des Echosignals $s_{e,2}$ mit dem zweiten Kanal gemessen werden,
- **dass** im dritten kernmagnetischen Messablauf ein Phasenunterschied des Inversionspulses (8) und des Aktivierungspulses (11) jeweils 90°, ein Phasenunterschied des ersten Refokussierungspulses (13) und des zweiten Refokussierungspulses (15) jeweils 180° und ein Phasenunterschied des Deaktivierungspulses (17) 270° betragen und dass ein negativer Realteil des Echosignals $s_{e,3}$ mit dem zweiten Kanal und ein positiver Imaginärteil des Echosignals $s_{e,3}$ mit dem ersten Kanal gemessen werden und
- **dass** im vierten kernmagnetischen Messablauf ein Phasenunterschied des Inversionspulses (8) und des Aktivierungspulses (11) jeweils 270°, ein Phasenunterschied des ersten Refokussierungspulses (13) und des zweiten Refokussierungspulses (15) jeweils 180° und ein Phasenunterschied des Deaktivierungspulses (17) 90° betragen und dass ein positiver Realteil des Echosignals $s_{e,4}$ mit dem zweiten Kanal und ein negativer Imaginärteil des Echosignals $s_{e,4}$ mit dem ersten Kanal gemessen werden.

11. Kernmagnetisches Durchflussmessgerät (1) mit einem Messrohr (2), einer Magnetisierungseinrichtung (3) und einer Messeinrichtung (4), wobei im Betrieb ein Medium (5) im Messrohr (2) vorhanden ist und die Magnetisierungseinrichtung (3) das Medium (5) im Messrohr (2) magnetisiert, **dadurch gekennzeichnet,** **dass** die Messeinrichtung (4) ausgebildet ist, im Betrieb

- mindestens einen kernmagnetischer Messablauf (6, 7) am im Messrohr (2) magnetisierten Medium (5) auszuführen,
- wobei der mindestens eine kernmagnetische Messablauf (6, 7) einen Inversionspuls (8) und $N = \{2, 3, 4, ...\}$ Akquisitionsvorgänge (9, 10) aufweist,
- wobei jeder der $N$ Akquisitionsvorgänge (9, 10) zu einem Startzeitpunkt $t_{s,n}$ mit $n = \{1, ..., N\}$ in Bezug auf den mindestens einen kernmagnetischen Messablauf (6, 7) beginnt und einen Aktivierungspuls (11), ein erstes Warteintervall (12) mit einer Dauer $\Delta t_d$, einen ersten Refokussierungspuls (13), ein Echointervall (14) mit einer Dauer $\Delta t_e$, einen zweiten Refokussierungspuls (15), ein zweites Warteintervall (16) mit der Dauer $\Delta t_d$ und einen Deaktivierungspuls (17) aufweist,
- im Echointervall (14) ein Echosignal $s_{e,n}$ zu messen, und
- eine longitudinale Relaxationszeitkonstante $T_1$ des Mediums (5) unter Verwendung der Echosignale $s_{e,1}, ..., s_{e,N}$ zu bestimmen.

12. Kernmagnetisches Durchflussmessgerät (1) nach Anspruch 11, **dadurch gekennzeichnet, dass** die Messeinrichtung (4) darüber hinaus zum Ausführen eines Verfahrens nach einem der Ansprüche 2 bis 10 ausgebildet ist.

## Claims

1. Method for operating a nuclear magnetic flowmeter (1), wherein the nuclear-magnetic flowmeter (1) has a measuring tube (2), a medium (5) is present in the measuring tube (2) and the medium (5) in the measuring tube is magnetized, **characterized in**

- **that** at least one nuclear-magnetic measuring process (6, 7) is carried out on the magnetized medium (5) in the measuring tube (2),
- **that** the at least one nuclear-magnetic measuring process (6, 7) includes an inversion pulse (8) and $N = \{2, 3, 4, ...\}$ acquisition sequences (9, 10),
- **that** each of the N acquisition sequences (9, 10) begins at a starting point in time $t_{s,n}$ with $n = \{1, ..., N\}$ in respect to the at least one nuclear-magnetic measuring process (6, 7) and has an activating pulse (11), a first waiting interval (12) with a duration $\Delta t_d$, a first refocusing pulse (13), an echo interval (14) with a duration $\Delta t_e$, a second refocusing pulse (15), a second waiting interval (16) with the duration $\Delta t_d$ and a deactivating pulse (17),
- **that** an echo signal $s_{e,n}$ is measured in the echo interval (14), and
- **that** a longitudinal relaxation time constant $T_1$ of the medium (5) is determined using the echo signals $s_{e,1}, ..., s_{e,N}$.

2. Method according to claim 1, **characterized in that** the duration $\Delta t_d$ is determined according to

$$\Delta t_d = t_{ref} - \frac{2\Delta t_{90}}{\pi}$$

and/or the duration $\Delta t_e$ is determined according to

$$\Delta t_e = 2t_{ref}$$

wherein $\Delta t_{ref}$ is a reference duration and $\Delta t_{90}$ is a duration of the activating pulse (11).

3. Method according to claim 2, **characterized in that** the reference duration $\Delta t_{ref}$ is determined using a duration of decaying of interferences, wherein the interferences are caused by the activating pulse (11) and/or the refocusing pulse (13).

4. Method according to any one of claims 1 to 3, **characterized in that** a time span between each of two successive starting points in time $t_{s,n}$ and $t_{s,n+1}$ is determined such that the time span increases, preferably increases exponentially.

5. Method according to any one of claims 1 to 4, **characterized in that** after the N acquisition steps (9, 10), a repeat interval (18) with a duration $\Delta t_w$ is waited for and that the duration $\Delta t_w$ is at least as long as the largest span between two successive starting points in time $t_{s,n}$ and $t_{s,n+1}$ or at least as long as the span from the first starting point in time $t_{s,1}$ in respect to one end of the inversion pulse (8).

6. Method according to any one of claims 1 to 5, **characterized in that** at least two nuclear-magnetic measuring processes (6, 7) are carried out such that, in each case, two chronologically successive echo signals $s_{e,n}$ and $s_{e,n+1}$ in the echo intervals (14) are measured in different nuclear-magnetic measuring processes.

7. Method according to any one of claims 1 to 6, **characterized in that** a $+180°_x$-pulse is used as the inversion pulse (8), a $+90°_x$-pulse is used as the activating pulse (11), a $-90°_x$-pulse is used as the deactivating pulse (17) and a $+180°_y$-pulse is used for both the first refocusing pulse (13) the second refocusing pulse (15).

8. Method according to any one of claims 1 to 7, **characterized in that** phase differences between the inversion pulse (8), the activating pulse (11), the first refocusing pulse (13), the second refocusing pulse (15), the deactivating pulse (17) and the echo signal $s_{e,n}$ are cycled.

9. Method according to claim 8, **characterized in**

- **that** a first nuclear-magnetic measuring process (6) and a second nuclear-magnetic measuring process (7) are carried out in respect to a phase of the inversion pulse (8) and of the activating pulse (11) in the first nuclear-magnetic measuring process (6)
- such that, in the first nuclear-magnetic measuring process (6), a phase difference of the first refocusing pulse (13) and of the second refocusing pulse (15) is 90° each, a phase difference of the deactivating pulse (17) is 180° and a phase difference of the echo signal $s_{e,1}$ is 0° and
- **that** in the second nuclear-magnetic measuring step (7), a phase difference of the inversion pulse (8) and of the activating pulse (11) is 180° each, a phase difference of the first refocusing pulse (13) and of the second refocusing pulse (15) is 90° each, a phase difference of the deactivating pulse (17) is 0° and a phase difference of the echo signal $s_{e,2}$ is 180°.

10. Method according to claim 8, **characterized in**

- **that** a first nuclear-magnetic measuring process (6), a second nuclear-magnetic measuring process (7), a third nuclear-magnetic measuring process and a fourth nuclear-magnetic measuring process are carried out in respect to a phase of the inversion pulse (8) and of the activating pulse (11) in the first nuclear-magnetic measuring process (6),
- such that in the first nuclear-magnetic measuring process (6), a phase difference of the first refocusing pulse (13) and of the second refocusing pulse (15) is 90° each and a phase difference of the deactivating pulse (17) is 180° and that a positive real part of the echo signal $s_{e,1}$ is measured with a first channel and a positive imaginary part of the echo signal $s_{e,1}$ is measured with a second channel,

- **that** in the second nuclear-magnetic measuring process (7), a phase difference of the inversion pulse (8) and of the activating pulse (11) is 180° each, a phase difference of the first refocusing pulse (13) and of the second refocusing pulse (15) is 90° each and a phase difference of the deactivating pulse (17) is 0° and that a negative real part of the echo signal $s_{e,2}$ is measured with the first channel and a negative imaginary part of the echo signal $s_{e,2}$ is measured with the second channel,

- **that** in the third nuclear-magnetic measuring process, a phase difference of the inversion pulse (8) and of the activating pulse (11) is 90° each, a phase difference of the first refocusing pulse (13) and of the second refocusing pulse (15) is 180° each and a phase difference of the deactivating pulse (17) is 270° and that a negative real part of the echo signal $s_{e,3}$ is measured with the second channel and a positive imaginary part of the echo signal $s_{e,3}$ is measured with the first channel and

- **that** in the fourth nuclear-magnetic measuring process, a phase difference of the inversion pulse (8) and of the activating pulse (11) is 270° each, a phase difference of the first refocusing pulse (13) and of the second refocusing pulse (15) is 180° each and a phase difference of the deactivating pulse (17) is 90° and that a positive real part of the echo signal $s_{e,4}$ is measured with the second channel and a negative imaginary part of the echo signal $s_{e,4}$ is measured with the first channel.

11. Nuclear-magnetic flowmeter (1) having a measuring tube (2), a magnetization means (3) and a measuring unit (4), wherein a medium (5) is present in the measuring tube (2) during operation and the medium (5) in the measuring tube (2) is magnetized, **characterized in that** the measuring unit (4) is designed, during operation,

- to carry out at least one nuclear-magnetic measuring process (6, 7) on the magnetized medium (5) in the measuring tube (2),
- wherein the at least one nuclear-magnetic measuring process (6, 7) includes an inversion pulse (8) and $N = \{2, 3, 4, ...\}$ acquisition sequences (9, 10),
- wherein each of the $N$ acquisition sequences begins at a starting point in time $t_{s,n}$ with $n = \{1, ..., N\}$ in respect to the at least one nuclear-magnetic measuring process (6, 7) and has an activating pulse (11), a first waiting interval (12) with a duration $\Delta t_d$, a first refocusing pulse (13), an echo interval (14) with a duration $\Delta t_e$, a second refocusing pulse (15), a second waiting interval (16) with the duration $\Delta t_d$ and a deactivating pulse (17),

- to measure an echo signal $s_{e,n}$ in the echo interval (14), and
- to determine a longitudinal relaxation time constant $T_1$ of the medium (5) using the echo signal $s_{e,1}, ..., s_{e,N}$.

12. Nuclear magnetic flowmeter (1) according to claim 11, **characterized in that** the measuring unit (4) is additionally designed to carry out a method according to any one of claims 2 to 10.


**Revendications**

1. Procédé pour faire fonctionner un débitmètre magnétique nucléaire (1), le débitmètre magnétique nucléaire (1) possédant un tube de mesure (2), un fluide (5) étant présent dans le tube de mesure (2) et le fluide (5) dans le tube de mesure (2) étant magnétisé, **caractérisé en ce**

- **qu'**au moins une séquence de mesure magnétique nucléaire (6, 7) est réalisée sur le fluide (5) magnétisé dans le tube de mesure (2),
- **que** l'au moins une séquence de mesure magnétique nucléaire (6, 7) possède une impulsion d'inversion (8) et N = {2, 3, 4, ...} opérations d'acquisition (9, 10),
- **que** chacune des N opérations d'acquisition (9, 10) commence à un point de départ $t_{s,n}$ avec n = {1, ..., N} en référence à l'au moins une séquence de mesure magnétique nucléaire (6, 7) et possède une impulsion d'activation (11), un premier intervalle d'attente (12) ayant une durée $\Delta t_d$, une première impulsion de refocalisation (13), un intervalle d'écho (14) ayant une durée $\Delta t_e$, une deuxième impulsion de refocalisation (15), un deuxième intervalle d'attente (16) ayant la durée $\Delta t_d$ et une impulsion de désactivation (17),
- **qu'**un signal d'écho $s_{e,n}$ est mesuré dans l'intervalle d'écho (14) et
- **qu'**une constante de temps de relaxation longitudinale $T_1$ du fluide (5) est déterminée en utilisant les signaux d'écho $s_{e,1}, ..., s_{e,N}$.

2. Procédé selon la revendication 1, **caractérisé en ce que** la durée $\Delta t_d$ est déterminée selon

$$\Delta t_d = t_{ref} - \frac{2 \Delta t_{90}}{\pi}$$

et/ou la durée $\Delta t_e$ selon

$$\Delta t_e = 2 t_{ref},$$

$\Delta t_{ref}$ désignant une durée de référence et $\Delta t_{90}$ une durée de l'impulsion d'activation (11).

3. Procédé selon la revendication 2, **caractérisé en ce que** la durée de référence $\Delta t_{ref}$ est déterminée en utilisant une durée d'une décroissance de perturbations, les perturbations étant provoquées par l'impulsion d'activation (11) et/ou la première impulsion de refocalisation (13).

4. Procédé selon l'une des revendications 1 à 3, **caractérisé en ce qu'**un intervalle de temps entre deux points de départ $t_{s,n}$ et $t_{s,n+1}$ respectivement successifs est déterminé de telle sorte que l'intervalle de temps augmente, de préférence augmente exponentiellement.

5. Procédé selon l'une des revendications 1 à 4, **caractérisé en ce qu'**après N opérations d'acquisition (9, 10), un intervalle de répétition (18) ayant une durée $\Delta t_w$ est attendu et **en ce que** la durée $\Delta t_w$ est au moins aussi longue que le plus grand intervalle de temps entre deux points de départ $t_{s,n}$ et $t_{s,n+1}$ successifs ou au moins aussi longue que l'intervalle de temps du premier point de départ $t_{s,1}$ par rapport à une fin de l'impulsion d'inversion (8).

6. Procédé selon l'une des revendications 1 à 5, **caractérisé en ce qu'**au moins deux séquences de mesure magnétiques nucléaires (6, 7) sont réalisées de telle sorte que deux signaux d'écho $S_{e,n}$ et $S_{e,n+1}$ respectivement successifs chronologiquement sont mesurés dans les intervalles d'écho (14) de séquences de mesure magnétiques nucléaires (6, 7) différentes.

7. Procédé selon l'une des revendications 1 à 6, **caractérisé en ce que** l'impulsion d'inversion (8) utilisée est une impulsion de $+180°_x$, l'impulsion d'activation (11) une impulsion de $+90°_x$, l'impulsion de désactivation (17) une impulsion de $-90°_x$ et la première impulsion de refocalisation (13) et la deuxième impulsion de refocalisation (15) respectivement une impulsion de $+180°_y$.

8. Procédé selon l'une des revendications 1 à 7, **caractérisé en ce que** les différences de phase entre l'impulsion d'inversion (8), l'impulsion d'activation (11), la première impulsion de refocalisation (13), la deuxième impulsion de refocalisation (15), l'impulsion de désactivation (17) et le signal d'écho $s_{e,n}$ sont échangées périodiquement.

9. Procédé selon la revendication 8, **caractérisé en ce**

   - **qu'**une première séquence de mesure magnétique nucléaire (6) et une deuxième séquence de mesure magnétique nucléaire (7) sont réalisées en référence à une phase de l'impulsion d'inversion (8) et de l'impulsion d'activation (11) dans la première séquence de mesure magnétique nucléaire (6) de telle sorte
   - **que** dans la première séquence de mesure magnétique nucléaire (6), une différence de phase de la première impulsion de refocalisation (13) et de la deuxième impulsion de refocalisation (15) est respectivement de 90°, une différence de phase de l'impulsion de désactivation (17) est de 180° et une différence de phase du signal d'écho $s_{e,1}$ est de 0° et
   - **que** dans la deuxième séquence de mesure magnétique nucléaire (7), une différence de phase de l'impulsion d'inversion (8) et de l'impulsion d'activation (11) est respectivement de 180°, une différence de phase de la première impulsion de refocalisation (13) et de la deuxième impulsion de refocalisation (15) est respectivement de 90°, une différence de phase de l'impulsion de désactivation (17) est de 0° et une différence de phase du signal d'écho $s_{e,2}$ est de 180°.

10. Procédé selon la revendication 8, **caractérisé en ce**

   - **qu'**une première séquence de mesure magnétique nucléaire (6), une deuxième séquence de mesure magnétique nucléaire (7), une troisième séquence de mesure magnétique nucléaire et une quatrième séquence de mesure magnétique nucléaire sont réalisées en référence à une phase de l'impulsion d'inversion (8) et de l'impulsion d'activation (11) dans la première séquence de mesure magnétique nucléaire (6) de telle sorte
   - **que** dans la première séquence de mesure magnétique nucléaire (6), une différence de phase de la première impulsion de refocalisation (13) et de la deuxième impulsion de refocalisation (15) est respectivement de 90° et une différence de phase de l'impulsion de désactivation (17) est de 180° et qu'une partie réelle positive du signal d'écho $s_{e,1}$ est mesurée avec un premier canal une partie imaginaire positive du signal d'écho $s_{e,1}$ est mesurée avec un deuxième canal,
   - **que** dans la deuxième séquence de mesure magnétique nucléaire (7), une différence de phase de l'impulsion d'inversion (8) et de l'impulsion d'activation (11) est respectivement de 180°, une différence de phase de la première impulsion de refocalisation (13) et de la deuxième impulsion de refocalisation (15) est respectivement de 90° et une différence de phase de l'impulsion de désactivation (17) est de 0° qu'une partie réelle négative du signal d'écho $s_{e,2}$ est mesurée avec le premier canal une partie imaginaire négative du signal d'écho $s_{e,2}$ est mesurée avec le deuxième canal,

- **que** dans la troisième séquence de mesure magnétique nucléaire, une différence de phase de l'impulsion d'inversion (8) et de l'impulsion d'activation (11) est respectivement de 90°, une différence de phase de la première impulsion de refocalisation (13) et de la deuxième impulsion de refocalisation (15) est respectivement de 180° et une différence de phase de l'impulsion de désactivation (17) est de 270° qu'une partie réelle négative du signal d'écho $s_{e,3}$ est mesurée avec le deuxième canal une partie imaginaire positive du signal d'écho $s_{e,3}$ est mesurée avec le premier canal et

- **que** dans la quatrième séquence de mesure magnétique nucléaire, une différence de phase de l'impulsion d'inversion (8) et de l'impulsion d'activation (11) est respectivement de 270°, une différence de phase de la première impulsion de refocalisation (13) et de la deuxième impulsion de refocalisation (15) est respectivement de 180° et une différence de phase de l'impulsion de désactivation (17) est de 90° qu'une partie réelle positive du signal d'écho $s_{e,4}$ est mesurée avec le deuxième canal une partie imaginaire négative du signal d'écho $s_{e,4}$ est mesurée avec le premier canal.

11. Débitmètre magnétique nucléaire (1) comprenant un tube de mesure (2), un dispositif de magnétisation (3) et un dispositif de mesure (4), un fluide (5) étant présent en fonctionnement dans le tube de mesure (2) et dispositif de magnétisation (3) magnétisant le fluide (5) dans le tube de mesure (2), **caractérisé en ce que** le dispositif de mesure (4) est configuré pour, en fonctionnement,

- réaliser au moins une séquence de mesure magnétique nucléaire (6, 7) sur le fluide (5) magnétisé dans le tube de mesure (2),
- l'au moins une séquence de mesure magnétique nucléaire (6, 7) possédant une impulsion d'inversion (8) et N = {2, 3, 4, ...} opérations d'acquisition (9, 10),
- chacune des N opérations d'acquisition (9, 10) commençant à un point de départ $t_{s,n}$ avec n = {1, ..., N} en référence à l'au moins une séquence de mesure magnétique nucléaire (6, 7) et possédant une impulsion d'activation (11), un premier intervalle d'attente (12) ayant une durée $\Delta t_d$, une première impulsion de refocalisation (13), un intervalle d'écho (14) ayant une durée $\Delta t_e$, une deuxième impulsion de refocalisation (15), un deuxième intervalle d'attente (16) ayant la durée $\Delta t_d$ et une impulsion de désactivation (17),
- mesurer un signal d'écho $s_{e,n}$ dans l'intervalle d'écho (14) et
- déterminer une constante de temps de relaxation longitudinale $T_1$ du fluide (5) en utilisant les signaux d'écho $s_{e,1}, ..., s_{e,N}$.

12. Débitmètre magnétique nucléaire (1) selon la revendication 11, **caractérisé en ce que** ce que le dispositif de mesure (4) est en outre configuré pour mettre en œuvre un procédé selon l'une des revendications 2 à 10.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2015088888 A1
- US 4570119 A
- US 5023551 A
- US 6841996 B2